# EUROPEAN PATENT SPECIFICATION

(11) **EP 2 977 718 B1**
(45) Date of publication and mention of the grant of the patent: **07.08.2019**
(21) Application number: 14770324.3
(22) Date of filing: 19.03.2014
(51) Int. Cl.: H01L 41/113, G01B 7/16, G01L 1/16

(54) **DISPLACEMENT SENSOR, PUSHING AMOUNT DETECTION SENSOR, AND TOUCH INPUT DEVICE**
VERSCHIEBUNGSSENSOR ZUR ERKENNUNG EINER VERSCHIEBUNGSSTRECKE UND BERÜHRUNGSEINGABEVORRICHTUNG
CAPTEUR DE DÉPLACEMENT, CAPTEUR DE DÉTECTION DE QUANTITÉ DE POUSSÉE, ET DISPOSITIF À ENTRÉE TACTILE

(30) Priority: 21.03.2013 JP 2013057478
(43) Date of publication of application: 27.01.2016
(73) Proprietor: Murata Manufacturing Co., Ltd., Nagaokakyo-shi, Kyoto 617-8555 (JP)
(72) Inventor: KAWAMURA, Hideki, Nagaokakyo-shi Kyoto 617-8555 (JP); ANDO, Masamichi, Nagaokakyo-shi Kyoto 617-8555 (JP)
(74) Representative: Lloyd, Patrick Alexander Desmond
(86) International application number: PCT/JP2014/057449
(87) International publication number: WO 2014/148521

(56) References cited:
- WO-A1-2011/125389
- WO-A1-2013/021835
- JP-A- H06 249 706
- JP-A- 2010 108 490
- JP-A- 2011 167 875
- JP-A- 2011 222 679
- JP-A- 2012 251 030
- US-A- 1 995 257
- US-A1- 2016 109 983

## Description

### Technical Field

The present invention relates to a displacement sensor that detects a displacement amount of a piezoelectric film, a push-in amount detection sensor that detects a push-in amount from a charge amount generated by pushing in an operation surface, and a touch type input device provided with the push-in amount detection sensor.

### Background Art

Conventionally, there have been proposed various piezoelectric devices that convert physical amounts such as a displacement amount and a vibration amount into an electric amount using a piezoelectric film.

For example, Unexamined Japanese Patent Publication No. 2012-232497 discloses a piezoelectric device in which a plurality of piezoelectric films are laminated. Patent document JP-06249706 is also an example of prior art.

In the piezoelectric device of Unexamined Japanese Patent Publication No. 2012-232497, a conductive film is arranged in each piezoelectric film in order to apply a voltage to the piezoelectric film.

It is difficult to directly form the conductive film on the piezoelectric film, and frequently each conductive film adheres to the piezoelectric film with an adhesive layer interposed therebetween.

In the piezoelectric device of Unexamined Japanese Patent Publication No. 2012-232497, the adhesive layer is formed as thin as possible in order to improve a resonant characteristic of the piezoelectric device, and the adhesive layer is formed such that the thickness of the adhesive layer does not exceed 1000 [nm].

However, in the case that the piezoelectric device is used as a displacement sensor for detecting the displacement amount, it is found that a characteristic or reliability of the sensor is not improved only by thinning the adhesive layer as much as possible. In contrast, it is also found that the characteristic or reliability of the sensor is not improved only by thickening the adhesive layer.

We have therefore appreciated that it would be desirable to provide a displacement sensor having the excellent sensor characteristic and reliability.

### SUMMARY OF THE INVENTION

The present invention relates to a displacement sensor having the following features and is defined by the independent claims, to which attention is now drawn. The displacement sensor includes a piezoelectric film that generates a charge according to a displacement amount, an electrode that is arranged so as to face the piezoelectric film, and an adhesive layer that is interposed between the piezoelectric film and the electrode. The adhesive layer has a higher relative permittivity than the piezoelectric film .

In the above configuration, a charge generated by the piezoelectric film can efficiently be taken out to an external circuit. Therefore, the degradation of detection sensitivity caused by the interposition of the adhesive layer between the electrode and the piezoelectric film can be restrained.

In the displacement sensor, preferably an electrostatic capacitance per unit area of the adhesive layer is at least double an electrostatic capacitance per unit area of the piezoelectric film.

In the above configuration, the degradation of the detection sensitivity can further be restrained.

In the displacement sensor, preferably the thickness of the adhesive layer ranges from 10 µm to 30 µm.

In the above configuration, peel-off of the electrode can be restrained while the degradation of the detection sensitivity is restrained, and generation of a void or the like can be restrained. Therefore, the reliability and an appearance can further be improved.

In the displacement sensor, the electrode may be formed on one of principal surfaces of a protective film.

An example of a specific configuration in which the electrode is formed is illustrated in the above configuration.

In the displacement sensor, preferably the piezoelectric film is made of polylactic acid stretched in at least a uniaxial direction.

In the displacement sensor, preferably the piezoelectric film is made of polylactic acid stretched in at least a uniaxial direction, and the thickness of the piezoelectric film ranges from 40 µm to 100 µm.

In the above configuration, the detection sensitivity can be improved.

Preferably a push-in amount detection sensor of the present invention detects a push-in amount from an operation surface using the above displacement sensor.

In the above configuration, the push-in amount detection sensor having the excellent detection sensitivity and reliability can be made using the displacement sensor.

The present invention relates to a touch type input device having the following features. The touch type input device includes the push-in amount detection sensor and an arithmetic circuit module that is connected to the electrode of the push-in amount detection sensor to detect the push-in amount from a detection signal based on a charge amount generated by the push-in amount detection sensor.

In the above configuration, the touch type input device having the excellent detection sensitivity and reliability can be made using the push-in amount detection sensor.

Accordingly, the displacement sensor having the excellent sensor characteristic and reliability can be made in the present invention.

### BRIEF EXPLANATION OF DRAWINGS

FIG. 1 is a perspective view illustrating an appearance of a touch type input device according to an embodiment of the present invention.
FIG. 2 is a sectional view illustrating the touch type input device of the embodiment.
FIG. 3A is a sectional view illustrating a push-in amount detection sensor of the embodiment, and FIG. 3B is an exploded sectional view of the push-in amount detection sensor.
FIG. 4 is a diagram illustrating a percentage of an output charge related to a relative permittivity ratio of a piezoelectric film to an adhesive layer.
FIG. 5 is a diagram illustrating a percentage of the output charge related to a ratio of (relative permittivity)/(thickness) of the piezoelectric film to (relative permittivity)/(thickness) of the adhesive layer.
FIG. 6 is a diagram illustrating a relationship between the thickness of an adhesive layer and an adhesive force.

### DETAILED DESCRIPTION OF THE EMBODIMENTS

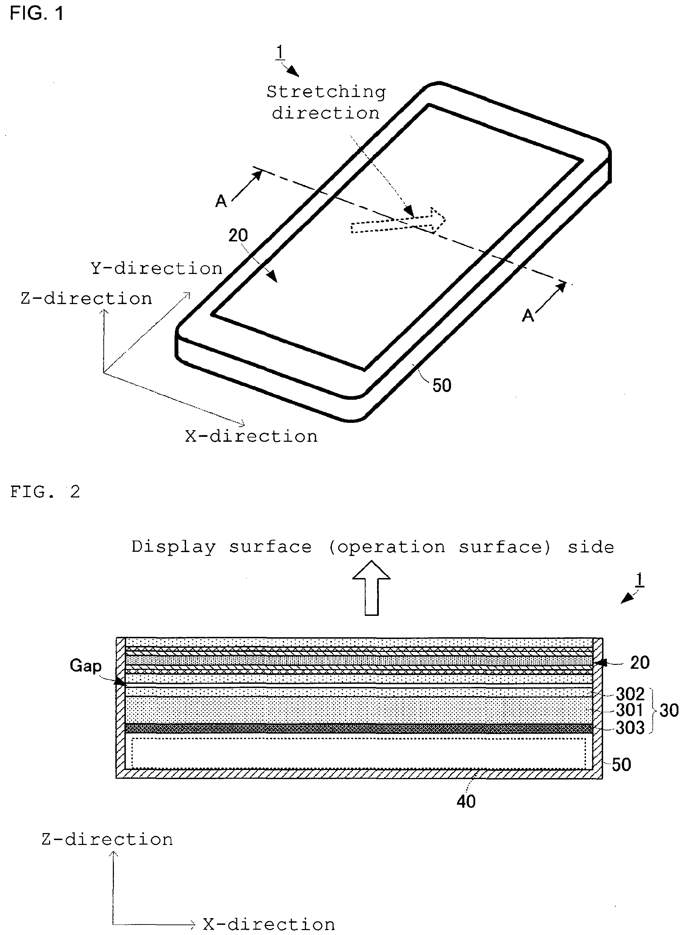

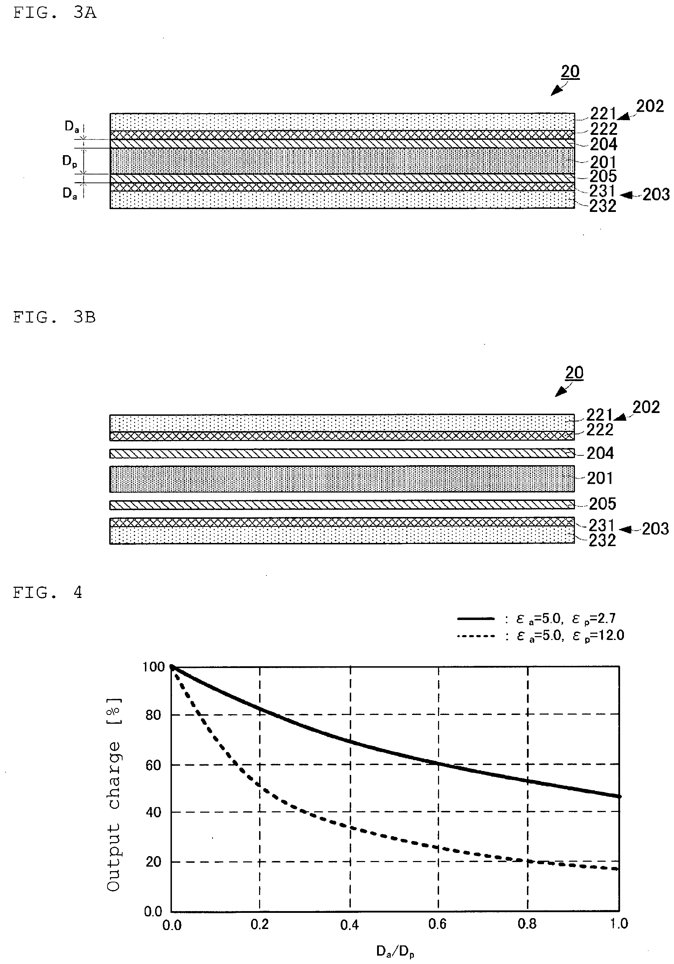

Hereinafter, a push-in amount detection sensor and a touch type input device according to an embodiment of the present invention will be described with reference to the drawings. FIG. 1 is a perspective view illustrating an appearance of the touch type input device of the embodiment. FIG. 2 is a sectional view illustrating the touch type input device of the embodiment. FIG. 3A is a sectional view illustrating a push-in amount detection sensor of the embodiment, and FIG. 3B is an exploded sectional view of the push-in amount detection sensor.

A touch type input device 1 includes a chassis 50 having a substantially rectangular parallelepiped shape. A surface side of the chassis 50 is opened. In the following description, it is assumed that a width direction (horizontal direction) of the chassis 50 is an X-direction, that a lengthwise direction (vertical direction) is a Y-direction, and that a thickness direction is a Z-direction. In the embodiment, the length in the X-direction of the chassis 50 is shorter than the length in the Y-direction of the chassis 50. Alternatively, the length in the X-direction of the chassis 50 may be equal to or longer than the length in the Y-direction of the chassis 50.

A push-in amount detection sensor 20, a display panel 30, and an arithmetic circuit module 40 are arranged in the chassis 50. The push-in amount detection sensor 20, the display panel 30, and the arithmetic circuit module 40 are arranged along the Z-direction in the order from the opening (display surface) side of the chassis 50. At this point, a portion including at least the push-in amount detection sensor 20 and the arithmetic circuit module 40 corresponds to the "touch type input device" of the present invention.

The push-in amount detection sensor 20 acts as the "displacement sensor", and includes a flat piezoelectric film 201, electrode-formed protective films 202 and 203, and adhesive layers 204 and 205.

The piezoelectric film 201 is made of a piezoelectric material that generates a charge amount according to a push-in amount. For example, the piezoelectric film 201 is a film made of a chiral polymer. In the embodiment, polylactic acid (PLA), particularly poly-L-lactic acid (PLLA) is used as the chiral polymer. PLLA is stretched in a uniaxial direction. The piezoelectric film 201 has a rectangular shape extending in the X-direction and Y-direction orthogonal to each other. The uniaxially-stretching direction is about 45° with respect to the X-direction and Y-direction.

A main chain of PLLA containing the chiral polymer has a helical structure. When PLLA is stretched in the uniaxial direction to orient molecules, PLLA has piezoelectricity. The uniaxially-stretched PLLA generates the charge by pushing in a flat plate surface of the piezoelectric film. At this point, the generated charge amount is uniquely fixed by a displacement amount of the flat plate surface that is displaced in the direction orthogonal to the flat plate surface by the push-in. A piezoelectric constant of the uniaxially-stretched PLLA falls into a category of extremely high piezoelectric constant in polymers. Accordingly, the displacement caused by the push-in can be detected with high sensitivity.

Preferably a stretching ratio ranges from about 3 times to about 8 times. When a heat treatment is performed after the stretching, crystallization of an extended chain crystal of polylactic acid is promoted to improve the piezoelectric constant. For biaxial stretching, an effect similar to that of the uniaxial stretching can be obtained by varying the stretching ratio in each axis. For example, in the case that the stretching ratio of 8 times is set to the X-axis direction while the stretching ratio of 2 times is set to the Y-axis direction orthogonal to the X-axis direction, the effect similar to the uniaxial stretching in which the stretching ratio of 4 times is set to the X-axis direction is obtained with respect to the piezoelectric constant. While the simply uniaxially-stretched film tears easily along the stretching-axis direction, strength can be increased to a certain degree by biaxial stretching.

In PLLA, the piezoelectricity is generated by a molecule orientation process such as the stretching, but it is not necessary to perform a polarization process unlike other polymers such as PVDF and other piezoelectric ceramics. The piezoelectricity of PLLA that does not belong to a ferroelectric material is not developed by ion polarization unlike ferroelectric materials such as PVDF and PZT, but derived from the helical structure that is of a characteristic structure of the molecule. Therefore, pyroelectricity that is generated in other ferroelectric materials is not generated in PLLA. Furthermore, the piezoelectric constant of PLLA is extremely stable over time, although in PVDF and the like, a variation in piezoelectric constant is observed over time and sometimes the piezoelectric constant decreases markedly. Accordingly, irrespective of a surrounding environment, the displacement caused by the push-in and relaxation of the push-in can be detected with high sensitivity.

Because PLLA has relative permittivity as low as about 2.5, a piezoelectric output constant (= piezoelectric g constant, g = d/ε^{T}) becomes large where d is a piezoelectric constant while ε^{T} is a dielectric constant. At this point, the piezoelectric g constant of PVDF having dielectric constant ε₃₃^{T} = 13 × ε₀ and piezoelectric constant d₃₁ = 25 pC/N is g₃₁ = 0.2172 Vm/N from the above equation. On the other hand, when the piezoelectric g constant of PLLA having piezoelectric constant d₁₄ = 10 pC/N is obtained in terms of g₃₁, d₃₁ = 5 pC/N is obtained because of d₁₄ = 2 × d₃₁, and the piezoelectric g constant is g₃₁ = 0.2258 Vm/N. Accordingly, with PLLA having piezoelectric constant d₁₄ = 10 pC/N, the sensitivity for detecting the push-in amount similar to that of PVDF can sufficiently be obtained. The inventors have experimentally obtained PLLA having d₁₄ = 15 to 20 pC/N, and the use of PLLA can detect the push-in and the relaxation of the push-in with high sensitivity.

Because PLLA has the extremely low relative permittivity, the relative permittivity of the adhesive layers 204 and 205 can easily be set higher than the relative permittivity of the piezoelectric film 201. In other words, a selection range of the material having the relative permittivity higher than the relative permittivity of the piezoelectric film 201 is widened, and the material for the adhesive layers 204 and 205 is easy to select.

The electrode-formed protective film 202 includes a flat protective film 221. The protective film 221 is made of a material having translucency and an insulating property. The protective film 221 is also made of a high-heat-resistance material. For example, the protective film 221 is made of a material such as PET and PEN. An electrode 222 is formed on one of principal surfaces of the protective film 221. The one of principal surfaces of the protective film 221 faces the piezoelectric film 201.

An organic electrode mainly containing ITO, ZnO, silver nano-wire, or polythiophene or an organic electrode mainly containing polyaniline is suitably used as the electrode 222. A conductive pattern having high translucency can be formed using these materials.

In the case that the electrode 222 is formed on the protective film 221, adhesion becomes higher compared with the case that electrode 222 is directly formed on the piezoelectric film 201. Accordingly, the reliability of the push-in amount detection sensor 20 is improved.

In the case that the electrode 222 is connected to an external circuit, thermo-compression bonding is usually adopted using an anisotropic conductive film. In the case that such heat treatments are performed, the protective film 221 is hardly thermally contracted compared with the piezoelectric film 201, and generation of disconnection of the electrode 222 can be restrained. Therefore, the reliability of the push-in amount detection sensor 20 can further be improved.

The electrode-formed protective film 203 includes a flat protective film 231. The protective film 231 is made of a material having translucency and an insulating property. The protective film 231 is also made of a high-heat-resistance material. For example, the protective film 231 is made of a material such as PET and PEN. An electrode 232 is formed on one of principal surfaces of the protective film 231. The one of principal surfaces of the protective film 231 faces the piezoelectric film 201.

An organic electrode mainly containing ITO, ZnO, silver nano-wire, or polythiophene or an organic electrode mainly containing polyaniline is suitably used as the electrode 232. A conductive pattern having high translucency can be formed using these materials.

In the case that the electrode 232 is formed on the protective film 231, the adhesion becomes higher compared with the case that electrode 232 is directly formed on the piezoelectric film 201. Accordingly, the reliability of the push-in amount detection sensor 20 is improved.

In the case that the electrode 232 is connected to an external circuit, thermo-compression bonding is usually adopted using an anisotropic conductive film. In the case that such heat treatments are performed, the protective film 231 is hardly thermally contracted compared with the piezoelectric film 201, and generation of disconnection of the electrode 232 can be restrained. Therefore, the reliability of the push-in amount detection sensor 20 can further be improved.

The adhesive layer 204 is a flat, and provided between the piezoelectric film 201 and the electrode-formed protective film 202. In the electrode-formed protective film 202, the surface on which the electrode 222 is formed adheres to one of the principal surfaces of the piezoelectric film 201 by the adhesive layer 204. Specific physical and electric features of the adhesive layer 204 are described later.

The adhesive layer 205 is a flat, and provided between the piezoelectric film 201 and the electrode-formed protective film 203. In the electrode-formed protective film 203, the surface on which the electrode 232 is formed adheres to the other principal surface of the piezoelectric film 201 by the adhesive layer 205. Specific physical, structural, and electric features of the adhesive layer 205 are described later.

Therefore, the charge generated by the piezoelectric film 201 is acquired by the electrodes 222 and 232, and a piezoelectric detection signal having a voltage value corresponding to the push-in amount can be output to the outside. The piezoelectric detection signal is output to the arithmetic circuit module 40 through wiring (not illustrated). The arithmetic circuit module 40 calculates a push-in amount from the piezoelectric detection signal.

A specific method for fixing the adhesive layers 204 and 205 will be described below. FIG. 4 is a diagram illustrating a percentage of an output charge related to a relative permittivity ratio of the piezoelectric film to the adhesive layer. In FIG. 4, the solid line indicates the percentage in the case where relative permittivity εₐ of the adhesive layer is higher than relative permittivity εₚ of the piezoelectric film. Specifically, the adhesive layer has a relative permittivity εₐ of 5.0, and the piezoelectric film has a relative permittivity εₚ of 2.7. In FIG. 4, the broken line indicates the percentage in the case where relative permittivity εₐ of the adhesive layer is lower than the relative permittivity εₚ of the piezoelectric film. Specifically, the adhesive layer has a relative permittivity εₐ of 5.0, and the piezoelectric film has a relative permittivity εₚ of 12.0. The percentage of the output charge indicates a percentage at which the charge generated by the piezoelectric film 201 is taken out to the external circuit by bending caused by the push-in.

As illustrated in FIG. 4, irrespective of a relationship between the relative permittivity εₐ of the adhesive layers 204 and 205 and the relative permittivity εₚ of the piezoelectric film 201, the output charge decreases with increasing ratio Dₐ/Dₚ of thicknesses Dₐ of the adhesive layers 204 and 205 to a thickness Dₚ of the piezoelectric film 201. From this viewpoint, preferably the thicknesses Dₐ of the adhesive layer films 204 and 205 is thinned. That is, the sensitivity for detecting the push-in amount increases with decreasing thicknesses Dₐ of the adhesive layer films 204 and 205.

As illustrated in FIG. 4, a decreasing rate of the output charge is low when the relative permittivity εₐ of the adhesive layers 204 and 205 is higher than the relative permittivity εₚ of the piezoelectric film 201. That is, the output charge hardly decreases even if the thickness ratio Dₐ/Dₚ increases. The degradation of the sensitivity for detecting the push-in amount can be restrained when the relative permittivity εₐ of the adhesive layers 204 and 205 is higher than the relative permittivity εₚ of the piezoelectric film 201.

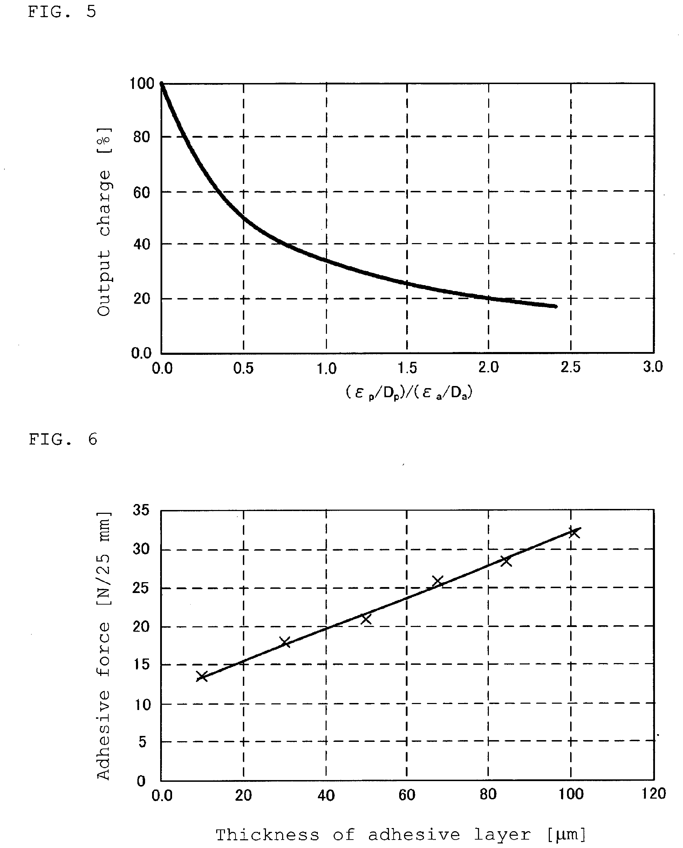

FIG. 5 is a diagram illustrating a percentage of the output charge related to a ratio of (relative permittivity)/(thickness) of the piezoelectric film to (relative permittivity)/(thickness) of the adhesive layer. The horizontal axis in FIG. 5 indicates the (relative permittivity)/(thickness) of the piezoelectric film divided by (relative permittivity)/(thickness) of the adhesive layer.

As illustrated in FIG. 5, the percentage of the output charge increases as a value εₚ/Dₚ of the relative permittivity to the thickness of the piezoelectric film 201 decreases with respect to a value εₐ/Dₐ of the relative permittivity to the thickness of the adhesive layers 204 and 205. That is, the sensitivity for detecting the push-in amount increases. In other words, the sensitivity for detecting the push-in amount increases as an electrostatic capacitance per unit area of the adhesive layers 204 and 205 increases with respect to an electrostatic capacitance per unit area of the piezoelectric film 201.

As illustrated in FIG. 5, the degradation of the output charge can suitably be restrained less than 50% when a εₚ/Dₚ of the relative permittivity to the thickness of the piezoelectric film 201 is less than or equal to about 0.5 times the value εₐ/Dₐ of the relative permittivity to the thickness of the adhesive layers 204 and 205, namely, when the electrostatic capacitance per unit area of the adhesive layers 204 and 205 is greater than or equal to about 2 times the electrostatic capacitance per unit area of the piezoelectric film 201.

FIG. 6 is a diagram illustrating a relationship between the thickness of the adhesive layer and an adhesive force. Data in FIG. 6 is cited from catalog values of double-sided adhesive tapes of TL-400S series of Lintec Corporation.

As illustrated in FIG. 6, the adhesive force is improved with increasing thicknesses of the adhesive layers 204 and 205. Therefore, the peel-off of the electrode-formed protective films 202 and 203 from the piezoelectric film 201 is hardly generated. It has been confirmed that a problem is not practically generated when the thickness of a material having the characteristic in FIG. 6 is greater than or equal to about 10 [µm]. Furthermore, with the thickness greater than or equal to about 10 [µm], irregularities can be filled in the principal surface (flat plate surface) of the piezoelectric film 201 and on the sides of the electrodes 222 and 232 of the electrode-formed protective films 202 and 203, and an appearance drawback such as generation of a void can be restrained.

On the other hand, although not illustrated, the translucency degrades with increasing thicknesses of the adhesive layers 204 and 205. A bending amount (push-in amount) of the piezoelectric film 201 caused by the push-in of the operation surface decreases with increasing thicknesses of the adhesive layers 204 and 205. Accordingly, the thicknesses of the adhesive layers 204 and 205 fall preferably within a predetermined range. For example, it has been confirmed that preferably the thickness of a material having the characteristic in FIG. 6 is less than or equal to about 30 [µm].

The thicknesses of the adhesive layers 204 and 205 can properly be set according to a material or a specification. Specifically, the minimum thickness may be fixed based on the peel-off strength and the appearance drawback preventing effect. The maximum thickness may be fixed based on the translucency and a shock-absorbing characteristic against the push-in, and the detection sensitivity in consideration of the relative permittivity.

Thus, in the push-in amount detection sensor 20, the relative permittivity εₐ of the adhesive layers 204 and 205 is set higher than the relative permittivity εₚ of the piezoelectric film 201. Therefore, the degradation of the output charge can be restrained, and the degradation of the detection sensitivity can be restrained.

In the push-in amount detection sensor 20, the electrostatic capacitance per unit area of the adhesive layers 204 and 205 is set higher than the electrostatic capacitance per unit area of the piezoelectric film 201. Preferably the electrostatic capacitance per unit area of the adhesive layers 204 and 205 is set greater than or equal to about 2 times the electrostatic capacitance per unit area of the piezoelectric film 201. Therefore, the degradation of the output charge can further be restrained, and the degradation of the detection sensitivity can further be restrained.

In the push-in amount detection sensor 20, the thicknesses of the adhesive layers 204 and 205 are set to an appropriate value in a predetermined thickness range. Therefore, the reliability can be improved, and the degradation of the detection sensitivity can be restrained.

Although a specific thickness is not indicated in the above description, preferably the thickness of the piezoelectric film 201 ranges from about 40 [µm] to about 100 [µm]. With such a thickness, the push-in amount detection sensor having the excellent push-in amount detection characteristic, reliability, appearance, and translucency can be made.

The touch type input device 1 including the push-in amount detection sensor 20 having the above characteristics will further be described below.

The display panel 30 includes a flat liquid crystal panel 301, a surface polarizing plate 302, and a rear-face reflecting plate 303. The liquid crystal panel 301 has a flat shape. In the liquid crystal panel 301, a voltage is applied to a driving electrode from the outside, whereby a liquid crystal orientation state changes so as to form a predetermined image pattern. The surface polarizing plate 302 has a behavior that transmits only a light wave vibrating in a predetermined direction. The rear-face reflecting plate 303 reflects the light from the side of the liquid crystal panel 301 toward the side of the liquid crystal panel 301. In the display panel 30 having the above configuration, the light reaches the rear-face reflecting plate 303 from the display surface side through the surface polarizing plate 302 and the liquid crystal panel 301, is reflected by the rear-face reflecting plate 303, and output onto the display surface side through the liquid crystal panel 301 and the surface polarizing plate 302. At this point, the display panel 30 forms a desired display image using the light output onto the display surface side by controlling a polarization characteristic of the surface polarizing plate 302 and a polarization characteristic of the liquid crystal that depends on the orientation state. The display image output from the display panel 30 is output from the operation surface through the push-in amount detection sensor 20. Therefore, an operator can visually recognize the display image.

A gap Gap is provided between the display panel 30 and the push-in amount detection sensor 20. The gap Gap is not necessarily provided. However, when the gap Gap is provided, the bending of the piezoelectric film 201 is not disturbed but the detection sensitivity can be improved.

The arithmetic circuit module 40 is arranged on the rear-face side of the display panel 30. As described above, the arithmetic circuit module 40 is connected to the electrodes 222 and 232 of the push-in amount detection sensor 20 to detect the push-in amount from the piezoelectric detection signal transmitted from the push-in amount detection sensor 20. The arithmetic circuit module 40 is fixedly installed in the chassis 50.

Thus, the touch type input device 1 having the high sensitivity for detecting the push-in amount and reliability can be made using the push-in amount detection sensor 20.

In the embodiment, PLA, particularly PLLA is used as the piezoelectric film by way of example. Alternatively, another piezoelectric film may be used. However, preferably the piezoelectric film has the lower relative permittivity.

The adhesive layer in the embodiment may be made of a bonding material or an adhesive material. As used herein, the bonding material means a material that is hardened and bonded by a chemical reaction or heat. The adhesive material means a soft material having elastic modulus of about 10⁵ Pa to about 10⁶ Pa, which is not hardened by heat or the like but bonded by an adhesive force of the material.

In the embodiment, the thicknesses of the adhesive layers 204 and 205 are equal to each other. As long as the adhesive layers 204 and 205 fall within the thickness range, the thicknesses of the adhesive layers 204 and 205 may be different from each other, or the adhesive layers 204 and 205 may be made of different materials.

In the embodiment, by way of example, the electrodes adhere to both the principal surfaces (both the flat surfaces) of the piezoelectric film 201. Alternatively, the electrode may adhere to at least one of the principal surfaces of the piezoelectric film 201.

In the embodiment, the touch type input device includes the display panel by way of example. Alternatively, paper in which an image used for operation is drawn may properly be arranged instead of the display panel. The image used for operation may be printed in the surface of the protective film 202.

In the embodiment, the touch type input device detects only the push-in amount by way of example. Alternatively, the touch type input device may have a function of detecting an operation position. In this case, for example, a flat electrostatic-capacitance-type position detection sensor may be arranged on the operation surface side (the opening side of the chassis 50) of the push-in amount detection sensor.

### Description Of Reference Symbols

- 1: touch type input device
- 20: push-in amount detection sensor
- 30: display panel
- 40: arithmetic circuit module
- 50: chassis
- 201: piezoelectric film
- 202,203: electrode-formed protective film
- 204,205: adhesive layer
- 221,231: base film
- 222,232: electrode
- 301: liquid crystal panel
- 302: surface polarizing plate
- 303: rear-face reflecting plate

## Claims

1. A displacement sensor comprising:
a piezoelectric film (201) that generates a charge according to a displacement amount;
an electrode (222) that is arranged so as to face the piezoelectric film; and
an adhesive layer (204) that is interposed between the piezoelectric film (201) and the electrode (222),
wherein the adhesive layer (204) has a higher relative permittivity than the piezoelectric film (201).

2. The displacement sensor according to claim 1, wherein an electrostatic capacitance per unit area of the adhesive layer (204) is at least double an electrostatic capacitance per unit area of the piezoelectric film (201).

3. The displacement sensor according to claim 2, wherein the thickness of the adhesive layer (204) ranges from 10 µm to 30 µm.

4. The displacement sensor according to any one of claims 1 to 3, wherein the electrode (222) is formed on one of principal surfaces of a protective film (202).

5. The displacement sensor according to any one of claims 1 to 4, wherein the piezoelectric film (201) is made of polylactic acid stretched in at least a uniaxial direction.

6. The displacement sensor according to any one of claims 1 to 4, wherein the piezoelectric film (201) is made of polylactic acid stretched in at least a uniaxial direction, and the thickness of the piezoelectric film (201) ranges from 40 µm to 100 µm.

7. A push-in amount detection sensor (20) that detects a push-in amount from an operation surface using the displacement sensor according to any one of claims 1 to 6.

8. A touch type input device (1) comprising:
the push-in amount detection sensor (20) according to claim 7; and
an arithmetic circuit module (40) that is connected to the electrode (222) of the push-in amount detection sensor to detect the push-in amount from a detection signal based on a charge amount generated by the push-in amount detection sensor.

## Patentansprüche

1. Wegsensor, Folgendes umfassend:
einen piezoelektrischen Film (201), der eine Ladung entsprechend einem Verschiebungsbetrag erzeugt;
eine Elektrode (222), die angeordnet ist, sodass sie dem piezoelektrischen Film zugewandt ist; und
eine Haftschicht (204), die zwischen dem piezoelektrischen Film (201) und der Elektrode (222) eingefügt ist, wobei die Haftschicht (204) eine höhere relative Permittivität als der piezoelektrische Film (201) aufweist.

2. Wegsensor nach Anspruch 1, wobei eine elektrostatische Kapazität pro Einheitsfläche der Haftschicht (204) wenigstens das Doppelte einer elektrostatischen Kapazität pro Einheitsfläche des piezoelektrischen Films (201) ist.

3. Wegsensor nach Anspruch 2, wobei die Dicke der Haftschicht (204) in einem Bereich von 10 µm bis 30 µm ist.

4. Wegsensor nach einem der Ansprüche 1 bis 3, wobei die Elektrode (222) auf einer der Hauptoberflächen eines Schutzfilms (202) ausgebildet ist.

5. Wegsensor nach einem der Ansprüche 1 bis 4, wobei der piezoelektrische Film (201) aus Polymilchsäure hergestellt ist, die in wenigstens einer uniaxialen Richtung gestreckt ist.

6. Wegsensor nach einem der Ansprüche 1 bis 4, wobei der piezoelektrische Film (201) aus Polymilchsäure hergestellt ist, die in wenigstens einer uniaxialen Richtung gestreckt ist, und die Dicke des piezoelektrischen Films (201) in einem Bereich von 40 µm bis 100 µm ist.

7. Erfassungssensor (20) für einen Eindrückbetrag, der einen Eindrückbetrag von einer Bedienoberfläche unter Verwendung des Wegsensors nach einem der Ansprüche 1 bis 6 erfasst.

8. Berührungseingabevorrichtung (1), Folgendes umfassend:
den Erfassungssensor (20) für einen Eindrückbetrag nach Anspruch 7; und
ein arithmetisches Schaltungsmodul (40), das mit der Elektrode (222) des Erfassungssensors für einen Eindrückbetrag verbunden ist, um den Eindrückbetrag aus einem Erfassungssignal auf der Grundlage eines durch den Erfassungssensor für einen Eindrückbetrag erzeugten Ladungsbetrags zu erfassen.

## Revendications

1. Capteur de déplacement comprenant :
un film piézoélectrique (201) qui génère une charge en fonction d'une quantité de déplacement ;
une électrode (222) qui est montée de manière à faire face au film piézoélectrique ; et
une couche adhésive (204) qui est interposée entre le film piézoélectrique (201) et l'électrode (222), la couche adhésive (204) ayant une permittivité relative supérieure à celle du film piézoélectrique (201).

2. Capteur de déplacement selon la revendication 1, dans lequel une capacité électrostatique par unité de surface de la couche adhésive (204) est au moins le double d'une capacité électrostatique par unité de surface du film piézoélectrique (201).

3. Capteur de déplacement selon la revendication 2, dans lequel l'épaisseur de la couche adhésive (204) est comprise entre 10 et 30 µm.

4. Capteur de déplacement selon l'une quelconque des revendications 1 à 3, dans lequel l'électrode (222) est formée sur l'une des surfaces principales d'un film protecteur (202).

5. Capteur de déplacement selon l'une quelconque des revendications 1 à 4, dans lequel le film piézoélectrique (201) est constitué d'acide polylactique étiré dans au moins une direction uniaxiale.

6. Capteur de déplacement selon l'une quelconque des revendications 1 à 4, dans lequel le film piézoélectrique (201) est constitué d'acide polylactique étiré dans au moins une direction uniaxiale et l'épaisseur du film piézoélectrique (201) est comprise entre 40 et 100 µm.

7. Capteur de détection de quantité en entrée (20) qui détecte une quantité en entrée à partir d'une surface de fonctionnement utilisant le capteur de déplacement selon l'une quelconque des revendications 1 à 6.

8. Dispositif d'entrée de type tactile (1) comprenant :
le capteur de détection de quantité d'insertion (20) selon la revendication 7 ; et
un module de circuit arithmétique (40) qui est connecté à l'électrode (222) du capteur de détection de quantité en entrée pour détecter la quantité en entrée à partir d'un signal de détection sur la base d'une quantité de charge générée par le capteur de détection de quantité en entrée.
